# EUROPEAN PATENT APPLICATION

(11) **EP 3 885 271 A1**
(43) Date of publication of application: **29.09.2021**
(21) Application number: 21162400.2
(22) Date of filing: 12.03.2021
(51) Int. Cl.: B64F 5/40, F16C 33/64

(54) **WHEEL BEARING HUB HEATER STORAGE DEVICE**

(30) Priority: 24.03.2020 US 202016828265
(71) Applicant: Honeywell International Inc., Charlotte, NC 28202 (US)
(72) Inventor: SHAIL, Richard, Charlotte, NC North Carolina 28202 (US); CRAFT, Stephen, Charlotte, NC North Carolina 28202 (US)
(74) Representative: Haseltine Lake Kempner LLP

(57) **Abstract**

A wheel bearing hub heater storage device is disclosed. The storage device may include a base portion defined by a base surface and a mounting surface opposite the base surface, the mounting surface including an aperture configured to receive and store a wheel bearing hub heater device. An electrical receptacle may receive an electrical plug of the wheel bearing hub heater device while the wheel bearing hub heater device is received in the aperture of the mounting surface. An electric circuit may supply current to the wheel bearing hub heater device to power a heating element of the wheel bearing hub heater device. An enclosure device movably mounted around the aperture may receive the wheel bearing hub heater device in the aperture in an open state and may enclose the wheel bearing hub heater device in the aperture in a closed state.

## Description

### TECHNICAL FIELD

Various embodiments of the present disclosure generally relate to wheel bearing hub heaters and, more particularly, to a wheel bearing hub heater storage device.

### BACKGROUND

Wheel bearing hub heaters for aircraft wheels use high voltage to heat a coil of the hub heater. The hub heater is then placed in the bearing hub and the heat from the coil causes the inner race of the bearing to expand so that the bearing may be easily removed. Thus, the bearing may be cleaned, repaired, and/or replaced. When inserting a bearing onto the wheel, the hub heater may likewise heat the bearing so that it may be expanded and then inserted onto the shaft. Such hub heaters may present a burn hazard to an operator and/or passersby due to the coil being exposed while the coil is hot (e.g., while the coil is heating up or cooling down). To alleviate this problem, a steel tube may be provided for stowing the hub heater while the coil is heating up or cooling down. However, the steel tube may be tipped over and the hot coil may be exposed. Therefore, the steel tube may be insufficient at preventing burn hazards. Further, the hub heater may damage the wheel, or parts of the wheel, if the hub heater is left in the hub for an extended period of time.

The present disclosure is directed to overcoming one or more of these above-referenced challenges.

### SUMMARY OF THE DISCLOSURE

According to certain aspects of the disclosure, a wheel bearing hub heater storage device is disclosed.

In one aspect, a wheel bearing hub heater storage device is disclosed. The wheel bearing hub heater storage device may include: a base portion defined by a base surface and a mounting surface opposite the base surface, the mounting surface comprising an aperture configured to receive and store a wheel bearing hub heater device; an electrical receptacle configured to receive an electrical plug of the wheel bearing hub heater device while the wheel bearing hub heater device is received in the aperture of the mounting surface; an electric circuit configured to supply current to the wheel bearing hub heater device to power a heating element of the wheel bearing hub heater device when the electrical plug of the wheel bearing hub heater device is received by the electrical receptacle; and an enclosure device movably mounted to the mounting surface around the aperture for receiving the wheel bearing hub heater device in the aperture in an open state and for enclosing the wheel bearing hub heater device in the aperture in a closed state.

In another aspect, a wheel bearing hub heater storage device is disclosed. The wheel bearing hub heater storage device may include: a base portion including defined by a base surface, a mounting surface parallel to the base surface, and one or more walls disposed between the base surface and the mounting surface, the mounting surface including an aperture for receiving a wheel bearing hub heater device; an electrical receptacle configured to receive an electrical plug of the wheel bearing hub heater device while the wheel bearing hub heater device is received in the aperture of the mounting surface; an electrical circuit configured to supply current to the wheel bearing hub heater device to power a heating element of the wheel bearing hub heater device when the electrical plug of the wheel bearing hub heater is received by the electrical receptacle; and an enclosure device mounted to the mounting surface around the aperture for receiving the wheel bearing hub heater device in the aperture in an open state and for enclosing the wheel bearing hub heater device in a closed state.

In yet another aspect, a method for safely heating a wheel bearing hub heater device is disclosed. The method may include: supplying current to the wheel bearing hub heater device when an electrical plug of the wheel bearing hub heater device is received by an electrical receptacle of a wheel bearing hub heater storage device to power a heating element of the wheel bearing hub heater device; sensing a heating condition of the wheel bearing hub heating device; and outputting an indication of the sensed heating condition.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 is a perspective side view illustration of a wheel bearing hub heater storage device, according to an exemplary embodiment of the present disclosure.
FIG. 2 is a partial front view illustration of the wheel bearing hub heater storage device of FIG. 1.
FIG. 3 is a top view illustration of the wheel bearing hub heater storage device along line 3-3 of FIG. 2.
FIG. 4 is a side view illustration of the wheel bearing hub heater storage device along line 4-4 of FIG. 2.
FIG. 5 is a side view illustration of the wheel bearing hub heater storage device along line 5-5 of FIG. 2.

### DETAILED DESCRIPTION

The following embodiments describe a wheel bearing hub heater storage device. As described above, wheel bearing hub heaters may present a burn hazard and/or may damage wheels or their components if left on for an extended period of time. Embodiments of the present disclosure may provide solutions to these problems by providing a wheel bearing hub heater storage device. The wheel bearing hub heater storage device of the present disclosure may include a closeable cage for protection from the hot coil of the hub. Further, the wheel bearing hub heater storage device may include a cradle and stowage area for storing the hub heater in the wheel bearing hub heater storage device when the coil is heating up or cooling down. An integral, fused controller may provide a timer with an alarm that may sound to notify an operator or other user that the power to the coil has been energized for a set amount of time (e.g., 15 minutes). Embodiments of the present disclosure may further include an emergency stop button for stopping current to the wheel bearing hub heater so that the coil immediately stops heating up. The exemplary wheel bearing hub heater storage device may accommodate any hub heater of any size for various sized aircraft wheels.

The subject matter of the present description will now be described more fully hereinafter with reference to the accompanying drawings, which form a part thereof, and which show, by way of illustration, specific exemplary embodiments. An embodiment or implementation described herein as "exemplary" is not to be construed as preferred or advantageous, for example, over other embodiments or implementations; rather, it is intended to reflect or indicate that the embodiment(s) is/are "example" embodiment(s). Subject matter can be embodied in a variety of different forms and, therefore, covered or claimed subject matter is intended to be construed as not being limited to any exemplary embodiments set forth herein; exemplary embodiments are provided merely to be illustrative. Likewise, a reasonably broad scope for claimed or covered subject matter is intended. Among other things, for example, subject matter may be embodied as methods, devices, components, or systems. Accordingly, embodiments may, for example, take the form of hardware, software, firmware, or any combination thereof (other than software per se). The following detailed description is, therefore, not intended to be taken in a limiting sense.

Throughout the specification and claims, terms may have nuanced meanings suggested or implied in context beyond an explicitly stated meaning. Likewise, the phrase "in one embodiment" as used herein does not necessarily refer to the same embodiment and the phrase "in another embodiment" as used herein does not necessarily refer to a different embodiment. It is intended, for example, that claimed subject matter include combinations of exemplary embodiments in whole or in part.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. Both the foregoing general description and the following detailed description are exemplary and explanatory only and are not restrictive of the features, as claimed.

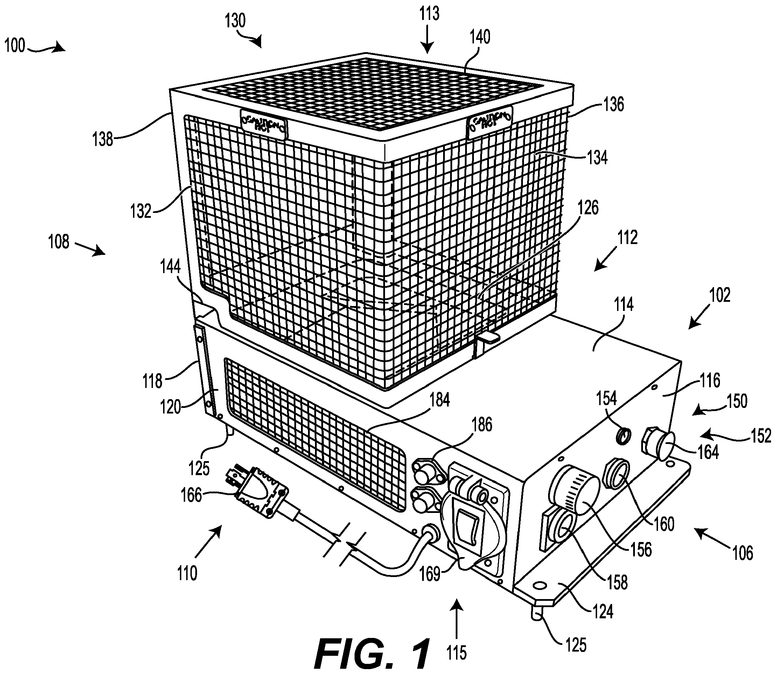

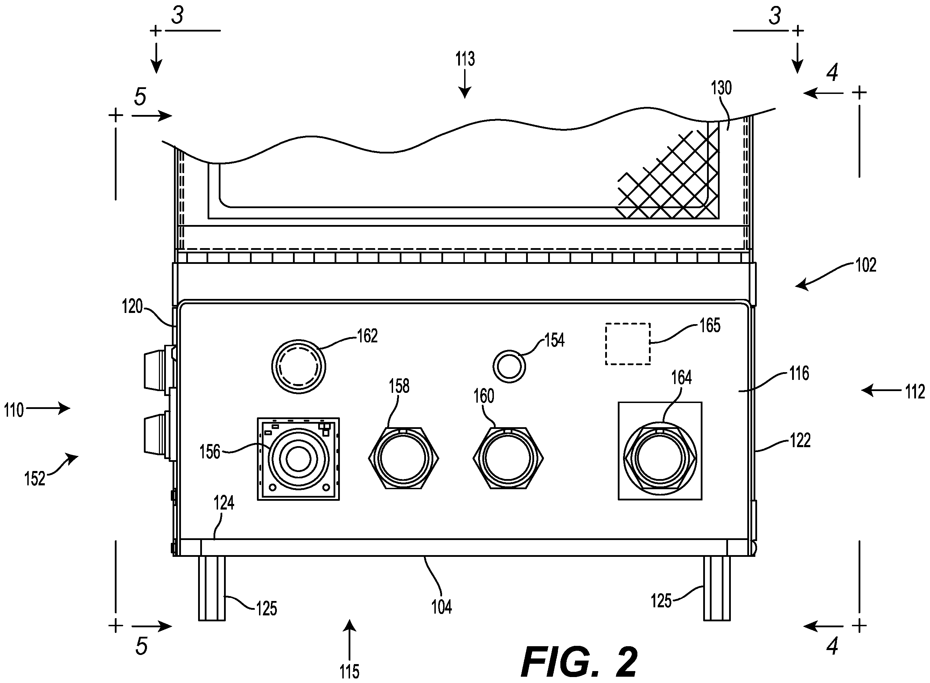

Referring now to the appended drawings, FIG. 1 shows a perspective view of an exemplary wheel bearing hub heater storage device 100, according to aspects of the disclosure. As shown in FIG. 1, wheel bearing hub heater storage device 100 (referred to herein as "hub heater storage device") may be generally box-like and have a base portion 102 and an enclosure device 130. Base portion 102 may include a base surface 104 (FIG. 2). Base surface 104 may extend in a lengthwise direction between a first end 106 and a second end 108, and in a width direction (substantially orthogonal to the length direction) between a third end 110 and a fourth end 112. That is, the first and second ends 106, 108 may be substantially parallel to each other, but substantially orthogonal to third and fourth ends 110, 112. Similarly, third and fourth ends 110, 112 may be substantially parallel to each other, but substantially orthogonal to first and second ends 106, 108.

Hub heater storage device 100 may further include a top end 113 and a bottom end 115 opposite the top end 113. Wheel bearing hub heater storage device 100 may also include a mounting surface 114 opposite its base surface 104 that is substantially parallel to and has substantially the same dimensions as base surface 104. Mounting surface 114 may be spaced from base surface 104. For example, base surface 104 may define a bottom end 115 of base portion 102 and mounting surface 114 may define a top end 113 of base portion 102. Hub heater storage device 100 may be formed of any suitable material including, but not limited to metals, polymers, compressed fibers, or the like. In one exemplary embodiment, hub heater storage device 100 may be formed from stainless steel and/or other materials with low thermal conductivity to reduce heat transfer. For example, the material of hub heater storage device 100 may include a thermal conductivity between .03-25 watts per meter kelvin (W/mK).

In one embodiment, first end 106 may define a front wall 116 that extends between and is substantially orthogonal to both base surface 104 and mounting surface 114. Similarly, second end 108 may define a rear wall 118 that also extends between and is substantially orthogonal to both base surface 104 and mounting surface 114. It is noted that walls 116 and 118 may be substantially parallel to each other. Further, third end 110 may define a first side wall 120 that extends between and is substantially orthogonal to both base surface 104 and mounting surface 114. Likewise, fourth end 112 may define a second side wall 122 that also extends between and is substantially orthogonal to both base surface 104 and mounting surface 114. It is noted that walls 120 and 122 may be substantially parallel to each other and substantially orthogonal to walls 116 and 118. Thus, base surface 104, mounting surface 114, and walls 116, 118, 120, 122 may define base portion 102 and base portion 102 may include a hollow box-like structure. It is understood that base portion 102 may include any shape and/or size as desired.

Hub heater storage device 100 may also include a flange 124. The flange 124 may extend outwardly and orthogonally from wall 116 at an intersection of wall 116 and base surface 104 disposed within first end 106. Therefore, flange 124 may lie in the same plane as base surface 104 and may be form a part of base surface 104. Accordingly, base surface 104 may extend lengthwise beyond front wall 116 at the first end 106. One or more legs 125 may extend orthogonally from a bottom end 115 of base surface 104. Legs 125 may provide support for hub heater storage device 100 such that hub heater storage device 100 may rest on a ground surface or other surface.

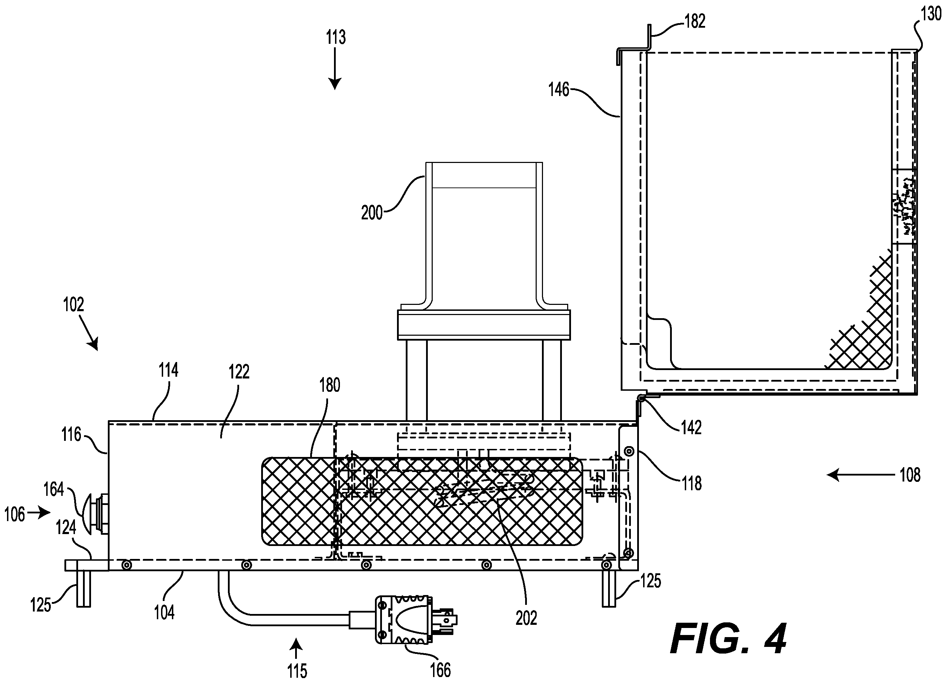

Mounting surface 114 may include an aperture 126 for receiving a wheel bearing hub heater device 200 (shown in FIG. 4). Wheel bearing hub heater device 200 (referred to herein as "hub heater device") may include a heating element, such as a coil 202, configured to be heated when hub heater device 200 is plugged in, as detailed further below. Aperture 126 may be on mounting surface 114 generally at the second end 108 and may be sized and shaped such that the hub heater device 200 may be inserted into base portion 102 through aperture 126. For example, aperture 126 may include a generally rectangular or square shape. Thus, hub heater device 200 may be mounted through mounting surface 114 to mount hub heater device 200 in hub heater storage device 100. Further, aperture 126 may include a size for receiving hub heater devices 200 of different sizes. As such, aperture 126 may include a larger size than the hub heater devices 200. To accommodate hub heater devices 200 of various sizes, hub heater storage device 100 may include one or more mounting plates 128, detailed further below. The mounting plates 128 may include different sized apertures and/or may be adjustable for receiving hub heater devices 200 of various sizes. The hub heater device 200 may be mounted on the mounting plates 128.

Hub heater storage device 100 may further include an enclosure device 130 for enclosing the hub heater device 200 after the hub heater device 200 has been mounted in hub heater storage device 100. Enclosure device 130 may be generally box-like. Enclosure device 130 may include a first wall 132, a second wall 134, a third wall 136, and a fourth wall 138. First wall 132 and third wall 136 may be parallel to each other, but substantially orthogonal to second wall 134 and fourth wall 138. Similarly, second and fourth walls 134, 138 may be substantially parallel to each other, but substantially orthogonal to first and second walls 132, 136. Further, first, second, third, and fourth walls 132, 134, 136, 138 may each be substantially orthogonal to mounting surface 114 when enclosure device 130 is in a closed state (as shown in FIG. 1).

Enclosure device 130 may also include a cover wall 140 that is substantially orthogonal to each of the first, second, third, and fourth walls 132, 134, 136, 138. The cover wall 140 may be located at a top end 113 of walls 132, 134, 136, 138 and may be coupled to each of the walls 132, 134, 136, 138. Accordingly, cover wall 140 may extend between each of the first, second, third, and fourth walls 132, 134, 136, 138 and may be substantially parallel to mounting surface 114 when enclosure device 130 is in the closed state. As shown in FIG. 1, the walls 132, 134, 136, 138, 140 of enclosure device 130 may be substantially cage-like such that the walls 132, 134, 136, 138, 140 may include small openings for enabling airflow into and out of the enclosure device 130 and base portion 102 (e.g., through aperture 126). However, it is understood that the walls 132, 134, 136, 138, 140 may include solid walls or may include any other types of openings over the entirety of the walls 132, 134, 136, 138, 140, or over a portion thereof, for enabling airflow through the walls 132, 134, 136, 138, 140. Further, it is understood that enclosure device 130 may include any number of walls and may include any size and/or shape as desired.

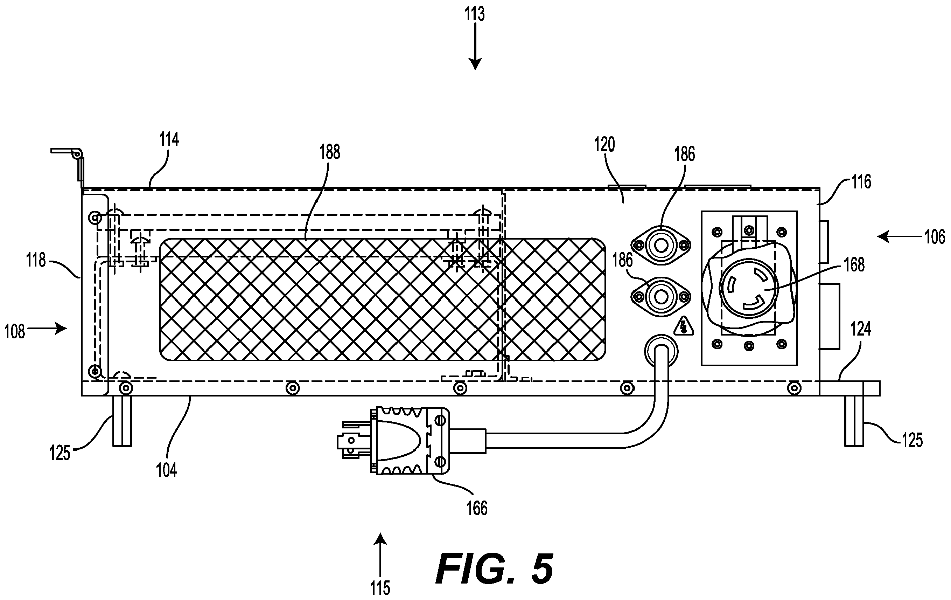

First wall 132 may further include an aperture 144 for receiving a chord (not shown) of the hub heater device 200 when mounted in the hub heater storage device 100. For example, the chord may be plugged (e.g., via a plug) into a corresponding receptacle 168 (shown in FIG. 5) of base portion 102, as detailed further below. Accordingly, the chord of hub heater device 200 may extend through enclosure device 130 (e.g., through aperture 144) and may be plugged into receptacle 168 when enclosure device 130 is in a closed state, as detailed further below.

Enclosure device 130 may further include an opening 146 (FIG. 4) on a bottom end 115. For example, opening 146 may define an entirety of the bottom end 115 of enclosure device 130. Opening 146 may be orthogonal to each of the first, second, third, and fourth walls 132, 134, 136, 138 and may be substantially parallel to cover wall 140. Thus, opening 146 may be substantially rectangular. However, it is understood that opening 146 may alternatively be defined by another suitable shape, if desired. Enclosure device 130 may be formed of any suitable material including, but not limited to metals, polymers, compressed fibers, or the like. In one exemplary embodiment, enclosure device 130 may be formed from stainless steel or other materials with low thermal conductivity to reduce heat transfer.

Enclosure device 130 may further include a hinge portion 142 that is coupled to base portion 102. Hinge portion 142 may be located at a bottom end 115 of third wall 136 of enclosure device 130. When enclosure device 130 is coupled to base portion 102, hinge portion 142 may be located at an intersection of mounting surface 114 and wall 118 of base portion 102. Accordingly, enclosure device 130 may be pivoted between an open state (shown in FIG. 4) and a closed state (shown in FIG. 1). The open state may enable the hub heater device 200 to be mounted in base portion 102 through aperture 126. For example, the enclosure device 130 may be pivoted about the hinge portion 142 to the open state. The open state may expose aperture 126 such that hub heater device 200 may be mounted in base portion 102. When the hub heater device 200 is mounted, enclosure device 130 may be pivoted to the closed state such that the enclosure device 130 encloses the hub heater device 200. For example, in the closed state, walls 132, 134, 136, 138 of enclosure device 130 may substantially surround hub heater device 200. Accordingly, enclosure device 130 may prevent the hot coil 202 of hub heater device 200 from being exposed and may prevent the hub heater device 200 from being knocked out of the hub heater storage device 100.

Hub heater storage device 100 may further include an electrical circuit 150. It is noted that only external components 152 of the electrical circuit 150 are shown in FIGs 1-5. The electrical circuit 150 may include various components for safely heating the coil 202 of hub heater device 200, as detailed further below.

FIG. 2 is a front view of hub heater device 100. As shown in FIG. 2, the first end 106 of hub heater storage device 100 may include external components 152 of electrical circuit 150 that may communicate inputs and/or outputs of electrical circuit 150. The external components 152 of electrical circuit 150 may include, for example, a heater on indicator 154, a timer input device 156 (e.g., a knob), a timer reset button 158, a start button 160, a speaker 162, and an emergency stop button 164. As used herein, a button is a knob, switch, disk, lever, handle, key, or any other device for controlling a function of the electrical circuit 150. It is understood that the buttons, knobs, and indicators may be physical components of the electrical circuit 150 and/or may be provided as digital components, for example, on a digital display. The external components 152 may each include electrical elements (not shown) connected together to form parts of electrical circuit 150. The electrical elements may be located, for example, inside base portion 102 adjacent front wall 116 such that the electrical elements may be located internally of hub heater storage device 100.

Electrical circuit 150 may further include a controller 165 (shown schematically as a dashed line in FIG. 2) located inside base portion 102 for receiving inputs of the electrical circuit 150 and controlling outputs, such as for example, aspects of external components 152. Hub heater storage device 100 may further include a plug 166 (shown in FIGs. 1 and 3-5) connected (e.g., by a cable) to the electrical circuit 150 for providing current and power to the components of electrical circuit 150. For example, the plug 166 may be connected (e.g., plugged in) to a corresponding power source to provide electrical current to the electrical circuit 150. It is understood that current and power may be provided to the electrical circuit 150 by any means known in the art, such as batteries or any other electric power supply. A receptacle 168 may also be connected to the electrical circuit 150. It is noted that the receptacle 168 is shown with a cover 169 in FIG. 1. The receptacle 168 may receive a corresponding plug (not shown) of the hub heater device 200. Accordingly, the electrical circuit 150 may provide current from the power source to the hub heater device 200 when the plug of the hub heater device 200 is connected to the receptacle 168 and plug 166 is connected to the power source. Thus, coil 202 may be heated when hub heater device 200 is mounted in hub heater storage device 100.

Heater on indicator 154 may indicate when hub heater device 200 is plugged in and heating up. Heater on indicator 154 may include, for example, a light, a speaker, a display, or any other type of indicator for indicating when hub heater device 200 is plugged in and/or coil 202 is heating up, as detailed further below. Timer knob 156 may enable an operator or other user to set a desired amount of time to trigger an alarm (e.g., via the controller 165). The controller 165 may include a timer and timer knob 156 may set the timer. The alarm may indicate that the hub heater device 200 has been energized for the desired amount of time. The alarm may be any type of alarm, such as, for example, an audible alarm, a visual alarm, or any other type of alarm. For example, the controller 165 may output the alarm via speaker 162, a light (not shown), and/or displayed on a visual display (not shown). Timer reset button 158 my include a button for resetting the timer to the set time. For example, when a user activates the timer reset button 158, the controller 165 may reset the timer to the set time. Start button 160 may be a button for starting the timer after the timer has been set by timer knob 156. For example, the operator or user may activate the start button 160 to start the timer. The emergency stop button 164 may be a button for stopping current to the hub heater device 200. For example, the operator or user may activate the emergency stop button 164 and electrical circuit 150 (e.g., controller 165) may include emergency stop logic to immediately stop heating the coil 202 of hub heater device 200.

The electrical circuit 150 may further include other internal components (not shown). The internal components may also be located, for example, inside the base portion 102 of hub heater storage device 100. The internal components may include one or more sensors (not shown) for sensing a heating condition of the hub heater device 200 when the hub heater device 200 is mounted in the hub heater storage device 100. The sensors may include electrical elements connected to electrical circuit 150. The sensors may include, for example, an infrared sensor, a temperature sensor, or the like. The heating condition may indicate whether the coil 202 of the hub heater device 200 is hot, heating up, or cooling down. The heating condition may also include a temperature reading of the coil 202. As such, a temperature sensor may sense the temperature of the coil and the electrical circuit 150 may display the temperature. The temperature may be displayed via, for example, a digital display, a temperature indicator, or the like. The temperature indicator may indicate when the temperature of the coil 202 exceeds a threshold temperature. The temperature indicator may be, for example, a light, a speaker, or any other device for indicating the temperature exceeds the threshold temperature. It is understood that the electrical circuit 150 may include any number of internal and external components for providing any function of hub heater storage device 100. For example, electrical circuit 150 may include a remote component for remotely controlling components or aspects of electrical circuit 150.

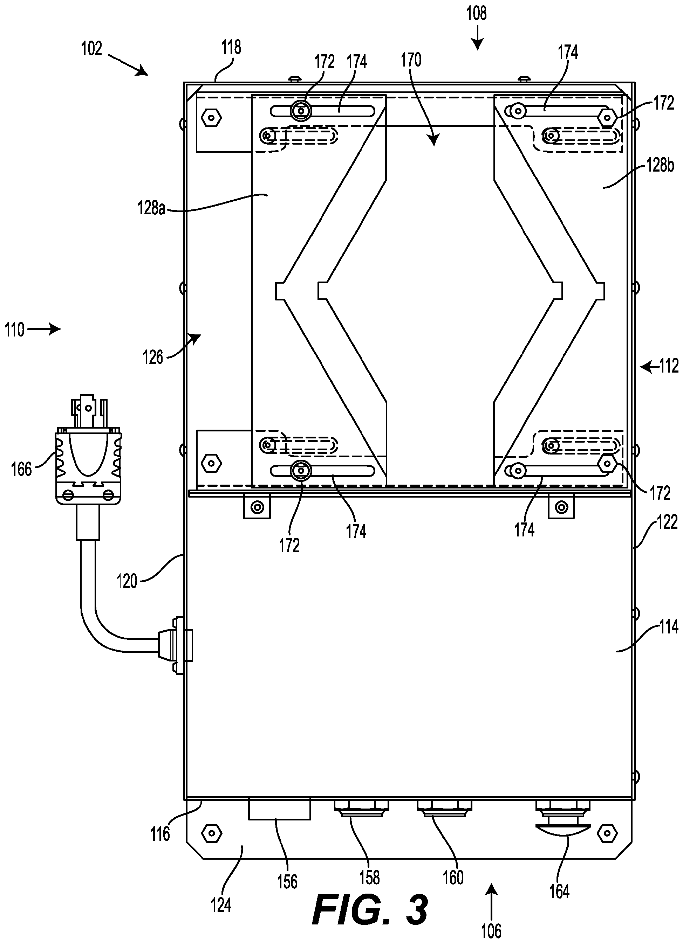

FIG. 3 is a top view of hub heater storage device 100 along line 3-3 of FIG. 2. As shown in FIG. 3, hub heater storage device 100 may include one or more mounting plates 128. The mounting plates 128 may be sized and shaped to receive the hub heater device 200 for mounting the hub heater device 200 in hub heater storage device 100. For example, the mounting plates 128 may include, for example, a first mounting plate 128a and a second mounting plate 128b. The first and second mounting plates 128a, 128b may be spaced from each other such that a gap 170 is formed between first and second mounting plates 128a, 128b. The first and second mounting plates 128a, 128b may each include a shape for receiving a portion of the hub heater device 200. Accordingly, when the hub heater device 200 is mounted in the hub heater storage device 100, the hub heater device 200 may be supported by mounting plates 128a, 128b and the coil 202 may extend into gap 170.

As described above, the hub heater device 200 may include one or more hub heater devices 200 each of a different size. As such, mounting plates 128a, 128b may be adjustable in order to increase and/or decrease gap 170 between the mounting plates 128a, 128b. Mounting plates 128a, 128b may be slidably attached to base portion 102 by one or more fastening mechanisms 172. The fastening mechanisms 172 may include, for example, bolts, screws, or the like. The mounting plates 128a, 128b may each include one or more elongated apertures 174 for receiving a corresponding fastening mechanisms 172 at portion thereof. The fastening mechanisms 172 may be loosened such that the mounting plates 128a, 128b may slide with respect to the fastening mechanisms 172 about the elongated apertures 174. When the mounting plates 128a, 128b are slid to a desired position, the fastening mechanisms 172 may be tightened to lock the mounting plates 128a, 128b in their current position. Accordingly, hub heater storage device 100 may accommodate hub heater devices 200 of various sizes.

In one embodiment, mounting plates 128 may include a single plate having an aperture to form gap 202. In this embodiment, mounting plate 128 may include one or more different single plates having various sized apertures (e.g., gap 170) corresponding to the various sized hub heater devices 200. Accordingly, mounting plate 128 may be removable and replaced with a different mounting plate 128 having a different sized aperture (e.g., gap 170).

FIG. 4 is a side view of hub heater storage device 100 along line 4-4 of FIG. 2. It is noted that FIG. 4 also depicts an exemplary hub heater device 200 mounted in the hub heater storage device 100. Further, enclosure device 130 is depicted in the open state in FIG. 4. As shown in FIG. 4, second side wall 122 may include an opening 180. Opening 180 may include a cage-like structure and may enable airflow into and out of base portion 102. Further, when hub heater device 200 is mounted in hub heater storage device 100, coil 202 may extend down into gap 170 such that coil 202 is exposed by opening 180. Accordingly, opening 180 may enable heat transfer out of base portion 102 while coil 202 is hot (e.g., heating up and/or cooling down).

As further shown in FIG. 4, hinge portion 142 of enclosure device 130 may be pivotably coupled to hinge portion A4 of base portion 102. Accordingly, enclosure device 130 may be pivoted between the open state (FIG. 4) and the closed state (FIG. 1). Enclosure device 130 may further include a handle 182. Handle 182 may enable an operator or other user to pivot the enclosure device 130 between the open state and closed state.

FIG. 5 is a side view of hub heater storage device 100 along line 5-5 in FIG. 2. As shown in FIG. 5, first side wall 120 may also include an opening 184. Opening 184 may include a cage-like structure and may enable airflow into and out of base portion 102. Further, when hub heater device 200 is mounted in hub heater storage device 100, coil 202 may extend down into gap 170 such that coil 202 is exposed by opening 184. Accordingly, opening 184 may enable heat transfer out of base portion 102 while coil 202 is hot (e.g., heating up and/or cooling down). It is understood that hub heater storage device 100 may include any number of openings having any size or shape for enabling airflow into, and out of, base portion 102.

As further shown in FIG. 5, electrical circuit 150 may also include receptacle 168 and one or more fuses 186. Fuses 186 may provide overcurrent protection for electrical circuit 150. The fuses 186 may include, for example, a metal wire or strip that melts when too much current flows through the wire or strip, thereby interrupting the current of the electrical circuit 150. Accordingly, the fuses 186 may provide a safety measure if the current through the electrical circuit 150 exceeds a predetermined threshold. The fuses 186 may be removed and replaced with fuses 186 of various predetermined thresholds for accommodating hub heater devices 200 of various sizes.

An exemplary method for safely heating a hub heater device 200 is also provided. Referring to FIGs. 1-5, in operation, an operator, technician, or other user may open the enclosure device 130 to the open state (FIG. 4) and place the hub heater device 200 in base portion 102. For example, hub heater device 200 may be mounted on mounting plates 128a, 128b through aperture 126. Enclosure device 130 may then be closed to the closed state (FIG. 1) such that the chord of hub heater device 200 is placed through aperture 144. The operator may set the timer using the timer input device 156 (e.g., the timer knob) and then plug in the plug of the hub heater device 200 into the receptacle 168. For example, the controller 165 may receive a timer input for setting the timer. The start button 160 may be activated to start the timer. For example, the controller 165 may start the timer when the start button 160 is activated.

Current may be provided to the hub heater device 200 for heating the coil 202. Controller 165 may output an indication of the heating condition. For example, the controller 165 may indicate that the coil 202 is currently being heated by activating the heater on indicator 154. Further, the controller 165 may receive a sensed heating condition from the one or more sensors. The controller 165 may output the sensed heating condition. For example, the controller 165 may receive a sensed temperature of the coil 202 and may output the sensed temperature via a temperature indicator and/or a digital display. The controller 165 may further output an alert when the sensed heating condition reaches and/or is above a predetermined threshold. For example, the controller 165 may output the alert (e.g., via speaker 162) when the temperature of the coil 202 exceeds a certain temperature. The controller 165 may also output (e.g., via speaker 162) an alert when the timer reaches zero.

In some instances, an operator may need and/or may desire to stop heating the coil 202 prior to the timer reaching zero or for other reasons. The operator may activate the emergency stop button 164. For example, the controller 165 may receive a signal from the emergency stop button 164 when the emergency stop button 164 is activated. The controller 165 may then stop providing current to the hub heater device 200.

The systems, apparatuses, devices, and methods disclosed herein are described in detail by way of examples and with reference to the figures. The examples discussed herein are examples only and are provided to assist in the explanation of the apparatuses, devices, systems, and methods described herein. None of the features or components shown in the drawings or discussed below should be taken as mandatory for any specific implementation of any of these the apparatuses, devices, systems, or methods unless specifically designated as mandatory. For ease of reading and clarity, certain components, modules, or methods may be described solely in connection with a specific figure. In this disclosure, any identification of specific techniques, arrangements, etc. are either related to a specific example presented or are merely a general description of such a technique, arrangement, etc. Identifications of specific details or examples are not intended to be, and should not be, construed as mandatory or limiting unless specifically designated as such. Any failure to specifically describe a combination or sub-combination of components should not be understood as an indication that any combination or sub-combination is not possible. It will be appreciated that modifications to disclosed and described examples, arrangements, configurations, components, elements, apparatuses, devices, systems, methods, etc. can be made and may be desired for a specific application. Also, for any methods described, regardless of whether the method is described in conjunction with a flow diagram, it should be understood that unless otherwise specified or required by context, any explicit or implicit ordering of steps performed in the execution of a method does not imply that those steps must be performed in the order presented but instead may be performed in a different order or in parallel.

It is intended that the specification and examples be considered as exemplary only, with a true scope and spirit of the disclosure being indicated by the following claims.

## Claims

1. A wheel bearing hub heater storage device, comprising:
a base portion defined by a base surface and a mounting surface opposite the base surface, the mounting surface comprising an aperture configured to receive and store a wheel bearing hub heater device;
an electrical receptacle configured to receive an electrical plug of the wheel bearing hub heater device while the wheel bearing hub heater device is received in the aperture of the mounting surface;
an electric circuit configured to supply current to the wheel bearing hub heater device to power a heating element of the wheel bearing hub heater device when the electrical plug of the wheel bearing hub heater device is received by the electrical receptacle; and
an enclosure device movably mounted to the mounting surface around the aperture for receiving the wheel bearing hub heater device in the aperture in an open state and for enclosing the wheel bearing hub heater device in the aperture in a closed state.

2. The wheel bearing hub heater storage device of claim 1, further comprising:
one or more sensors for sensing a heating condition of the wheel bearing hub heater device, the one or more sensors in communication with the electrical circuit.

3. The wheel bearing hub heater storage device of claim 2, wherein the electrical circuit is configured to output an alert when the sensed heating condition reaches a predetermined threshold.

4. The wheel bearing hub heater storage device of claim 1, wherein the electrical circuit is configured to output an alert after a predetermined amount of time.

5. The wheel bearing hub heater storage device of claim 4, wherein the electrical circuit further includes a timer input device for setting the predetermined amount of time.

6. The wheel bearing hub heater storage device of claim 1, wherein the electrical circuit further includes an emergency stop logic configured to shut off the current to the wheel bearing hub heater device when an emergency stop button is activated.

7. The wheel bearing hub heater storage device of claim 1, wherein the base portion further includes one or more mounting plates located inside the base portion for receiving the wheel bearing hub heater device.

8. The wheel bearing hub heater storage device of claim 7, wherein the mounting plates are adjustable to different positions for receiving wheel bearing hub heater devices of different sizes.

9. The wheel bearing hub heater storage device of claim 1, wherein a material of the wheel bearing hub heater storage device is between .03-25 watts per meter kelvin.

10. A method for safely heating a wheel bearing hub heater device, the method comprising:
supplying current to the wheel bearing hub heater device when an electrical plug of the wheel bearing hub heater device is received by an electrical receptacle of a wheel bearing hub heater storage device to power a heating element of the wheel bearing hub heater device;
sensing a heating condition of the wheel bearing hub heating device; and
outputting an indication of the sensed heating condition.

11. The method of claim 10, wherein the outputting an indication of the sensed heating condition includes outputting an alert when the sensed heating condition exceeds a predetermined threshold.

12. The method of claim 11, wherein the alert is an audible alert.

13. The method of claim 10, further comprising outputting an alert after a predetermined amount of time.

14. The method of claim 13, further comprising receiving the predetermined amount of time from a user input.

15. The method of claim 10, further comprising stopping current to the wheel bearing hub heater device upon activation of an emergency stop button.
